Europäisches Patentamt

European Patent Office

Office européen des brevets

(11) Publication number: **0 310 170 B1**

# EUROPEAN PATENT SPECIFICATION

(45) Date of publication of patent specification: **23.03.94**  (51) Int. Cl.5: **H03K 9/06**

(21) Application number: **88202028.2**

(22) Date of filing: **16.09.88**

(54) **Converter device.**

(30) Priority: **30.09.87 BE 8701063**

(43) Date of publication of application:
**05.04.89 Bulletin 89/14**

(45) Publication of the grant of the patent:
**23.03.94 Bulletin 94/12**

(84) Designated Contracting States:
**AT BE CH DE ES FR GB IT LI NL SE**

(56) References cited:
**FR-A- 2 195 423**
**US-A- 3 867 650**

**IEEE JOURNAL OF SOLID STATE-CIRCUITS,
vol. SC-22, no. 6, December 1987, IEEE, New
York, US; D. SALLAERTS et al.: "A Single-
Chip U-Interface Transceiver for ISDN"**

(73) Proprietor: **ALCATEL N.V.**
**Strawinskylaan 537,**
**(World Trade Center)**
**NL-1077 XX Amsterdam(NL)**
(84) Designated Contracting States:
**CH DE ES FR GB IT LI NL SE AT**

(73) Proprietor: **BELL TELEPHONE MANUFACTUR-
ING COMPANY Naamloze Vennootschap**

Francis Wellesplein 1
B-2018 Antwerp(BE)
(84) Designated Contracting States:
BE

(72) Inventor: **Haspeslagh, Didier René**
**Tieltsestraat 10**
**B-8750 Harelbeke(BE)**
Inventor: **Rabaey, Dirk Herman Lutgardis Cor-
nelius**
**Rode Dreef 18**
**B-2110 Wijnegem(BE)**

(74) Representative: **Vermeersch, Robert et al**
**BELL TELEPHONE MANUFACTURING COM-
PANY**
**Naamloze Vennootschap**
**Patent Department**
**Francis Wellesplein 1**
**B-2018 Antwerpen (BE)**

## EP 0 310 170 B1

**Description**

The invention relates to a converter device including a first conversion circuit for converting a digital input signal to an output signal, said conversion depending upon parameters that may deviate from their reference values.

Such a converter device is for instance mentioned in the British patent application No 8131147 and includes e.g. an RC lowpass filter which serves for converting by integration a digital pulse density modulated (PDM) input signal to an analog output signal. However, if this digital input signal varies between voltage levels which are not stable the result of this integration is inaccurate. An obvious solution for this problem consists in preceding the integrator circuit by a converter circuit wherein the voltage levels of the input signal are substituted by very stable voltage levels. However, generally this solution can not be executed because such voltage levels are not available due to their price. In general, only relatively stable supply voltages are available which only undergo relatively small variations - of e.g. 1% - in function of their load i.e. of the number of circuits they feed. Hence when these supply voltages are used for converting the input signal and before supplying the latter to the mentioned integrator circuit the result of this integration is still inaccurate, although to a limited extent.

A converter device of the above type is also known from US patent 3,867,650. Therein a delta modulator is described which includes control logic (12) with a pair of current switch gates (16, 17) each of which has an output whose level is either high or low, the difference between these levels being equal to the sum of three transistor base-emitter junction voltage drops. However, the thus obtained difference depends on temperature and therefore on the currents drawn by the transistors providing these voltage drops (46, 47, 48) and on the supply voltages, so that the result of integrating the current switch gate output signal is also inaccurate.

An object of the invention is to provide a converter device which makes it possible to convert the input signal to a stable output signal although no stable supply voltages are available.

According to the invention as defined by Claim 1 this object is achieved due to the fact that a second conversion circuit performs on an auxiliary digital input signal a conversion to an auxiliary output signal under the control of regulated digital control signals in a way similar to the conversion performed by said first conversion circuit, said auxiliary digital input signal being so chosen that said auxiliary output signal depends on said parameters in a similar way as said output signal and has a nominal value which is independent from said parameters and their deviations, that said first conversion circuit converts said digital input signal to said output signal under the control of said regulated digital control signals which are dependent on said parameters and are provided by a digital control signal generator forming part, together with said second conversion circuit and an error measurement circuit, of a negative feedback control loop which regulates said regulated digital control signals in such a way that the influence thereon of said deviations of said parameters from their reference values is compensated, and that said error measurement circuit compares said auxiliary output signal with said nominal value and provides thereby an error measurement signal proportional to the difference between the compared signals and function of said deviations of said parameters from their reference values, said error measurement signal controlling said digital control signal generator which accordingly regulates said regulated control signals.

The invention is thus based on the insight that by converting in the second conversion circuit the second input signal in a similar way as the first input signal the auxiliary signals thus obtained are in a similar way as the output signal of the first conversion circuit dependent from these supply voltages - the mentioned parameters - and also on the insight that by the choice of the second input signal it is possible to provide such auxiliary signals that the measurement signals for the compensation of the control signals may be easily derived therefrom.

Another characteristic of the present converter device is that said second conversion circuit generates auxiliary signals which are each only dependent from a respective one of said parameters, and that said measurements circuit derives from said auxiliary signals respective measurement signals which are respectively only function of the influence of a variation of the corresponding parameter and which control said signal generator in such a manner that this variation is compensated on a respective one of said control signals.

By making the auxiliary signals each dependent from one parameter only each measuring signal is also only dependent from this parameter and a control signal may be compensated in an easy way.

The above mentioned and other objects and features of the invention will become more apparent and the invention itself will be best understood by referring to the following description of an embodiment taken in conjunction with the accompanying drawings wherein :

Fig. 1 represents a converter device according to the invention;

2

Fig. 2 shows the conversion circuit CC1 of Fig. 1 in detail;

Fig. 3 to Fig. 6 represent waveforms used to illustrate the operation of the converter device;

Fig. 7 represents an integrator and comparator circuit to be substituted for the circuits LPF2 and COMP2 of Fig. 1.

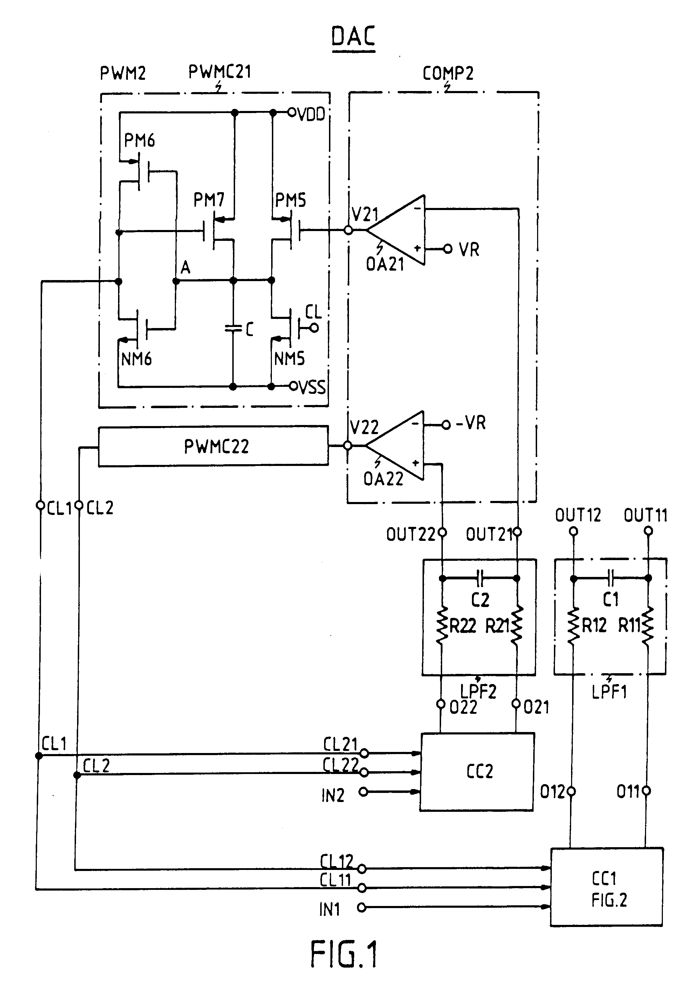

The converter device DAC represented in Fig. 1 has a signal input IN1, a reference signal input IN2, and a difference output with output terminals OUT11 and OUT12 and includes a main circuit, comprising the series connection of a conversion circuit CC1 and a lowpass filter LPF1, and a closed loop control circuit which is coupled with CC1 and comprises the series connection of a conversion circuit CC2, a lowpass filter LPF2, a measurement and comparator circuit COMP2 and a signal generator or pulse width modulator PWM2.

The converter device operates with the supply voltages VDD, VSS and VAG which are nominally equal to 2.5 volts, -2.5 Volts and 0 Volt respectively. Hereby VAG is a fixed voltage, but VDD and VSS may change over ±37 milli-Volts.

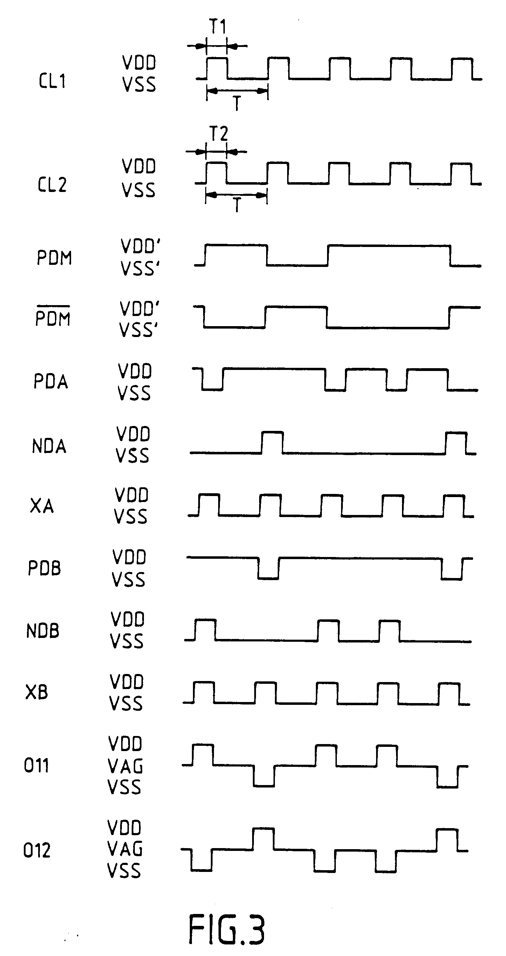

The converter device serves for converting a digital binary Pulse Density Modulated, or PDM, input signal with a bit frequency of 15.36 Megabit/sec to an analog output signal with a bandwidth of 120 kHz. This PDM signal was for instance previously derived from a 120 kbit/sec digital signal by means of a digital sigma-delta modulator operating at a frequency of 120x128 = 15.36 Megabit/sec and of the type described in the article "Design Methodology for Sigma Delta Modulator" by B.P. Agrawal et al, IEEE Journal, 1983, pp. 360-369. This PDM signal is for instance represented in Fig. 3 and varies between the voltage levels VDD′ and VSS′ which are nominally equal to VDD and VSS but may vary over ± 370 milli-Volts. Due to this the latter PDM signal is not at all suitable for being converted to an analog signal by integration in the lowpass filter LPF1. For this reason, prior to being supplied to this filter LPF1, this PDM signal is first converted in the conversion circuit CC1 which operates with the more accurate voltages VDD and VSS, but wherein moreover the possible small changes of these voltages are compensated by the regulating circuit CC2, LPF2, COMP2, PWM2.

The conversion circuit CC1 of the main circuit has the signal input IN1, two control of clock inputs CL11 and CL12 which are connected to respective outputs CL1 and CL2 of the regulating circuit and a difference output with two output terminals O11 and O12. In their turn these terminals are connected to like named inputs of the 120 kHz lowpass filter LPF1 constituted by two series resistances R11 and R12 and a shunt capacitor C1, the output terminals OUT11 and OUT12 of these resistances constituting the difference output of the device.

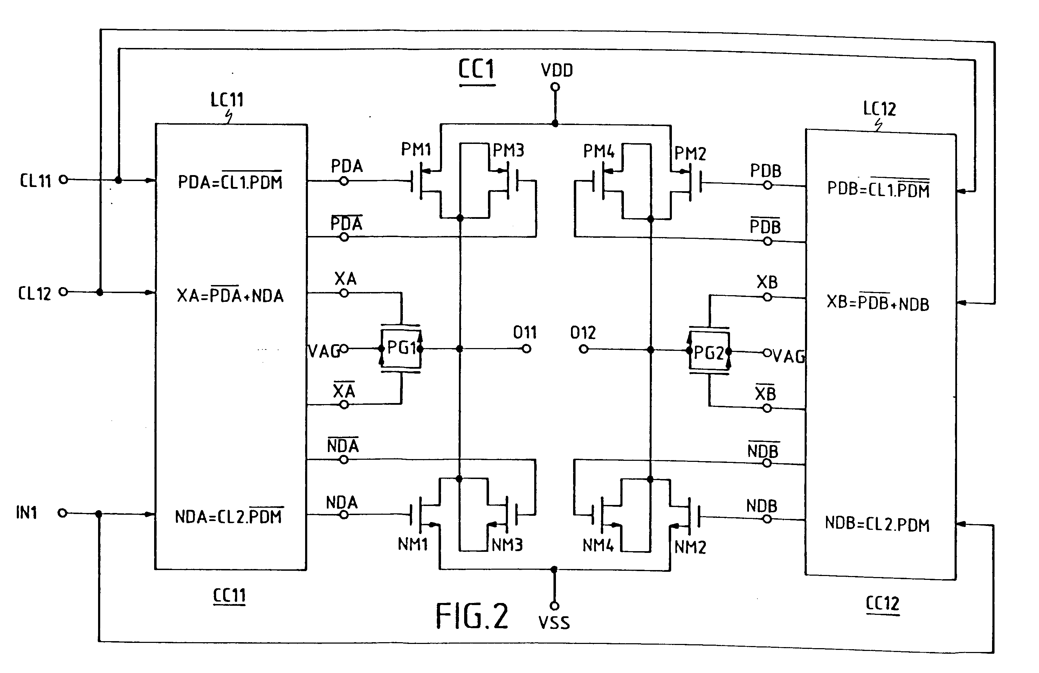

The conversion circuit CC1 is represented in detail in Fig. 2 and includes two similar converting circuits CC11 and CC12 which are represented in the left hand side and in the right hand side of the figure respectively. The converting circuit CC11 includes a logic circuit LC11 with signal IN1 and clock inputs CL11 and CL12 and with gate outputs PDA, $\overline{PDA}$, XA, $\overline{XA}$, NDA and $\overline{NDA}$ on which like named gating signals PDA, $\overline{PDA}$, XA, $\overline{XA}$, NDA and $\overline{NDA}$ are generated. The converting circuit CC1 moreover includes a switching circuit which is connected between VDD and VSS and which comprises the series connection of two electronic switches, i.e. PMOS transistor PM1 and NMOS transistor NM1, whose intercoupled drain electrodes constitute the output terminal O11 of the circuit. This terminal also constitutes the output of a third electronic switch, i.e. pass gate transistor PG1 whose input is connected to VAG and whose control electrodes are controlled by the gating signals XA and $\overline{XA}$. The drain electrode of each of the MOS transistors PM1 and NM1 is connected to the intercoupled source and drain electrodes of an associated compensation MOS transistor, i.e. PM3 and NM3. The gate electrodes of these transistors are controlled by means of the respective gating signals $\overline{PDA}$ and $\overline{NDA}$ which are phase-shifted over 180 degrees with respect to the gating signal PDA and NDA controlling the gate electrodes of PM1 and NM1 respectively.

In a similar way the converting circuit CC12 includes a logic circuit LC12 with signal input IN1 and clock inputs CL11 and CL12 and with gate outputs PDB, $\overline{PDB}$, XB, $\overline{XB}$, NDB, $\overline{NDB}$ as well as a switching circuit including the transistors PM2, PM4, NM2, NM4 and PG2 and having an output terminal O12. The logic circuit LC12 generates at its outputs the like named gating signals PDB, $\overline{PDB}$, XB, $\overline{XB}$, NDB and $\overline{NDB}$ controlling the last mentioned transistors.

It is now assumed that the following signals shown in Fig. 3 are respectively applied to the clock inputs CL11 and CL12 and to the signal input IN1 of the converting circuit CC1 :

- the control signal or clock signal CL1 comprising pulses with period T and nominal duration T1 = $\frac{T}{3}$ and varying between VDD and VSS;
- the control signal or clock signal CL2 also comprising pulses with period T and nominal duration T2 = $\frac{T}{3}$ and varying between VDD and VSS;
- the above mentioned PDM signal varying between VDD′ and VSS′.

3

In this case the gating signals appearing at the outputs of LC11 and LC12 and controlling the associated switching circuits may be represented by the following Boolean functions :

$$PDA = \overline{CL1.PDM} \qquad (1)$$

$$NDA = CL2.\overline{PDM} \qquad (2)$$

$$XA = \overline{\overline{PDA}+NDA} \qquad (3)$$

$$PDB = CL1.\overline{PDM} \qquad (4)$$

$$NDB = CL2.PDM \qquad (5)$$

$$XB = \overline{\overline{PDB}+NDB} \qquad (6)$$

The output O11 of CC11 thus becomes : equal to VDD when PM1 is conductive, i.e. when PDA = VSS; equal to VSS when NM1 is conductive, i.e. when NDA = VDD; equal to VAG when PG1 is conductive, i.e. when XA = VSS, so that the output signal O11 is a ternary signal with levels VDD, VSS and VAG, i,e, comprising positively directed first pulses with duration T1 varying between VDD and VAG and negatively directed second pulses with duration T2 varying between VAG and VSS. Also the output signal O12 is a ternary signal and is normally the complement of O11.

In each converting circuit, such as CC11, the levels VDD' and VSS' with duration T of the PDM input signal are thus each converted to a plurality of output pulses with period T and of which the duration is equal to the duration of the pulses of the respective clock signals CL1 and CL2. Indeed, when for instance the output signal O11 is considered then it follows from Fig. 3 that :
- each level VDD' of the PDM input signal is converted to a plurality of one or more positively directed output pulses with period T and duration T1 determined by the clock signal CL1 and with an amplitude comprised between VDD and VAG;
- each level VSS' of the PDM input signal is converted to a plurality of one or more negatively directed output pulses with a period T and duration T2 determined by the clock signal CL2 and with an amplitude comprised between VAG and VSS.

In connection with the conversion circuit CC1 it should also be noted that the function of each of the compensation transistors PM3/4 and NM3/4 is to eliminate spurious signals which would otherwise appear at the drain electrodes of PM1/2, NM1/2 and therefore on the outputs O11 and O12 due to the presence of spurious capacitances between the electrodes of the transistor. This happens by generating spurious signals of opposite sign on these electrodes. Indeed, when for instance the set PM1/3 is considered the application of the control signals PDA and $\overline{PDA}$ to the respective gate electrodes of PM1 and PM3 has for effect that the positively and negatively directed spurious pulse which occur on the common drain electrodes of PM1 and PM3 at the start and at the end of a positive pulse of PDA are eliminated by the negatively and positively directed spurious pulses which respectively occur at the start and at the end of a negatively directed pulse of $\overline{PDA}$.

When the above considered ternary signals O11 and O12 of the conversion circuit CC1 are applied to the lowpass filter LPF1 they are integrated therein. The increase/decrease of the voltages on each of the output terminals OUT11 and OUT12 of this filter produced by a first/second pulse is thus dependent on the surface of this pulse, i.e. of its duration T1/T2 and of the magnitude of the voltage level VDD/VSS. To make this integration independent from a variation of VDD and/or VSS, or from whatever parameter, the duration of the clock signals is so regulated that the surface of each pulse of O11 and O12 remains substantially constant, independent from this variation. This happens by means of the regulating circuit CC2, LPF2, COMP2, PNM2 wherein the influence of a variation of VDD and/or VSS, or from whatever parameter, is measured on a reference signal which is converted and integrated in the same way as the PDM input signal and wherein the result of this measurement is used to compensate this variation by a variation of the duration of the clock signals CL1 and CL2. More particularly, the influences of the variations of VDD and VSS are measured separately and these measurements are used to regulate therewith the duration T1 and T2 of the clock signals CL1 and CL2. This will be described hereinafter.

The conversion circuit CC2 of the regulating circuit is the same as the conversion circuit CC1 and includes two converting circuits CC21 and CC22 (not shown) each with an input IN2 which is now used as a reference signal input, with two clock inputs CL21 and CL22 connected to the respective outputs CL1 and CL2, and with a respective output O21 and O22. These outputs are in their turn connected to like named inputs of the 120 kHz lowpass filter LPF2 which is identical to LPF1 and which has output terminals OUT21 and OUT22 of a difference output. This filter includes the series resistance R21 and R22 and the shunt

EP 0 310 170 B1

capacitor C2. To the input IN2 is applied a PDM reference signal PDMR which is for instance continuously equal to VDD due to which the following gating signals appear at the outputs of the logic circuits of CC2, as follows from the relations to (6) and because $\overline{\text{PDMR}}$ = VSS :

XA = PDA = $\overline{\text{CL1}}$     (7)

NDA = VSS     (8)

XB = NDB = CL2     (9)

PDB = VDD     (10)

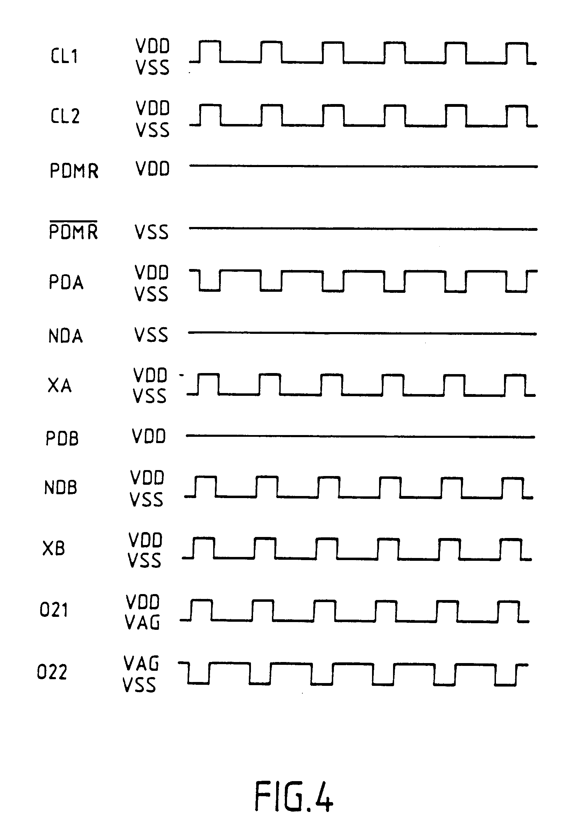

These gating signals are represented in Fig. 4, it being assumed that the clock signals CL1 and CL2 have their nominal duration T1 = T2 = T/3. The gating signals NDA, $\overline{\text{NDA}}$ and PDB, $\overline{\text{PDB}}$ block the transistors NM1/3 and PM2/4 respectively, whilst the remaining gating signals control the transistor pairs PM1/3 and NM2/4 and the passgate transistors PG1 and PG2 (all not shown) of CC2 insuch a way that the shown signals O21 and O22 appear at the outputs O21 and O22 thereof.

The signal O21 only consists of a continuous series of positively directed first pulses with a duration T1 determined by CL1 and an amplitude comprised between VDD and VAG. It is therefore a positively directed binary signal or, in other words, a ternary signal wth a maximum positive value which is independent from VSS.

In a similar way the signal O22 only consists of a continuous series of negatively directed second pulses with a duration T2 determined by CL2 and an amplitude comprised between VAG and VSS. It is therefore a negatively directed binary signal or, in other words, a ternary signal with a maximum negative value which is independent from VDD.

By means of these binary signals O21 and O22 it is now easy to first assert and then compensate variations of VDD and VSS respectively, as described hereinafter.

These binary signals O21 and O22 are supplied to the lowpass filter LPF2, which as already mentioned is identical to LPF1, due to which filtered or integrated auxiliary signals appear at the output terminals OUT21 and OUT22 of this filter. Since the signals O21 and O22 are constituted by a continuous series of positively and negatively directed first and second pulses of duration T1 and T2 and amplitudes VDD-VAG and VAG-VSS respectively, the amplitude of the signals OUT21 and OUT22 during each period T is on the average respectively equal to (assuming VAG = 0)

VDD.$\frac{T1}{T}$     (11)

VSS.$\frac{T2}{T}$     (12)

and therefore nominally equal to the reference voltage

$$VR = \frac{2.5}{3} \quad Volts \qquad (13)$$

$$and \ -VR = \frac{-2.5}{3} \quad Volts \qquad (14)$$

since T1 = T2 = T/3 and VDD = -VSS = 2.5 Volts.

When VDD undergoes a variation then the amplitude of OUT21 deviates from the nominal value VR, whilst the amplitude OUT22 deviates from the nominal value -VR when VSS undergoes a variation. To measure these differences V21 and V22 of the auxiliary signals OUT21 and OUT22 with respect to VR and -VR, and which are zero in the nominal case, these auxiliary signals OUT21 and OUT22 are supplied to the measurement or comparator circuit COMP2 including two operational amplifiers OA21 and OA22 which operated as comparators. The minus input of OA21 is connected to the output terminal OUT21 of LPF2, whilst the reference voltage VR is connected to its plus input, so that the measurement signal V21 at the like named output terminal V21 of OA21 increases/decreases when the auxiliary signal on OUT21 decreases/increases. The reference voltage -VR is applied to the minus input of OA22, whilst its plus input is coupled to the output terminal OUT22 of LPF2, so that the measurement signal V22 at the like named

5

output terminal V22 of OA22 increases/decreases when the auxiliary signal on OUT22 increases/decreases.

The outputs V21 and V22 of OA21 and OA22 are connected to like named inputs of two clocked pulse width modulator circuits PWMC21 and PWMC22 forming part of the clock signal generator or pulse width modulator PWM2 and having outputs CL1 and CL2. Because both these circuits are identical only PWMC21 is represented in detail.

This clocked pulse width modulator circuit PWMC21 includes three branches connected between VDD and VSS : two of them each consist of the series connection of a PMOS transistor and an NMOS transistor, i.e. PM5, NM5 and PM6, NM6 and the third consists of the series connection of PMOS transistor PM7 and capacitor C, the junction point A of PM7 and C being connected to the joined drain electrodes of PM5 and NM5 as well as to the joined gate electrodes of PM6 and NM6. The drain electrodes of PM6 and NM6 and the gate electrode of PM7 are interconnected and constitute the output CL1 of PWMC21.

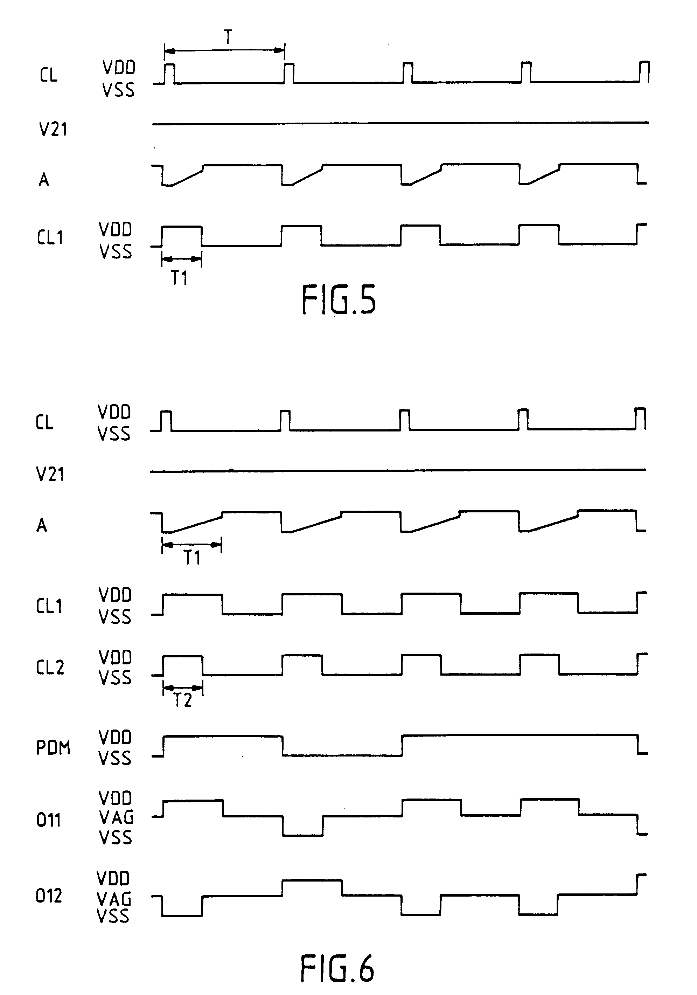

The operation of the pulse width modulator circuit PWMC21 is as follows when it is assumed that the lower or higher measurement signal V21 shown in Fig. 5 or 6 and provided by the comparator circuit COMP2 is applied to the gate of transistor PM5, whilst the shown clock signal C1 with period with period T is supplied to the gate of NM5. During the positively directed pulses of CL transistor NM5 becomes conductive due to which the possibly charged capacitor C is discharged towards VSS. Because point A is brought at this voltage VSS transistor PM6 becomes conductive due to which VDD appears at the output CL1 and NM6 is blocked, i.e. the invertor PM6, NM6 is triggered into another position. Also PM7 is then blocked. During the negatively directed pulses of CL transistor NM5 is blocked, due to which capacitor C is charged via PM5 with a time constant deetermined by the value of this capacitor and the value of the resistance constituted by PM5 and determined by the measurement signal V21. When due to this charging operation the voltage in the point A has become sufficiently high the invertor PM6, NM6 is again triggered to another position. This means that PM6 is blocked, whereas NM6 becomes conductive as a consequence of which the voltage on the output CL1 becomes equal to VSS. At this moment also PM7 becomes conductive due to which capacitor C is then charged via this transistor at a higher speed.

As long as the voltage VDD and the duration T1 of the pulses of the signal O11 have their nominal value, the surface of each of the (positively directed) first pulses of the signal O21 have their nominal value. As a consequence also the auxiliary signal OUT21 and the measurement signal V21 have their nominal value and also the pulses of CL1 have their nominal duration T1. However, if the amplitude of VDD changes then also the amplitude of this measurement signal changes due to which also the duration of the pulses of the clock signal CL1 is changed to compensate the variation of VDD. Indeed, this duration or width is dependent on the resistance of PM5 which is determined by the amplitude of the error signal V21. In other words, the clock signal CL1 is a signal which is pulse width modulated in function of the deviation of VDD from its nominal value.

Fig. 5 shows the nominal value wherein the measurement signal V21 of OA21 has its nominal value, due to which the pulses of the clock signal CL1 also have their nominal duration T1 = T/3. On the contrary, in Fig. 6 the pulses of the clock signal CL1 have a longer duration than their nominal duration because the measurement signal V21 has a higher value than its nominal value. Such a higher value of V21 is the result of a decrease of the voltage VDD. Indeed, upon a decrease of VDD the auxiliary signal OUT21 or

$$VDD \cdot \frac{T1}{T} = \frac{VDD}{3}$$

at the output OUT21 of the lowpass filter LPF2 decreases below the reference value VR due to which V21 increases. As a consequence transistor PM5 becomes less conductive and thus constitutes a higher resistance due to which the capacitor C in the circuit PWMC21 is charged more slowly than in the nominal case. As a result the duration of the pulses of the clock signal CL1 becomes larger, as indicated in Fig. 6. In its turn the consequence thereof is that the duration of the positively directed pulses of the signal O11 become larger due to which the average value of this signal increases. This average increases until the measurement signal V21 is again zero, at which moment the effect of the decrease of VDD is eliminated.

From the above it follows that the regulating circuit CC2, LPF2, COMP2, PWM2, wherein OA21 and PWMC21 are used, regulates the width T1 of the pulses of the clock signal CL1 in function of VDD in such a way that the surface of the pulses of the signal O21, and therefore of the positively directed pulses of O11 which are obtained in the same manner as O21, is independent from a variation of VDD and/or whatever other parameter. In a similar way the same regulator circuit, but now via OA22 and PWMC21, regulates the width T2 of the pulses of the clock signal CL2 in function of VSS so that the surface of the pulses of the intermediate clock signal O22, and therefore of the negatively directed pulses of O21, is independent from a

6

variation of VSS and/or whatever other parameter. When the thus regulated clock signals CL1 and CL2 are supplied to the circuit CC1 then the operation of this circuit is independent from a variation of VDD and/or VSS and/or whatever other parameter because - as described above - such a variation is compensated by a variation of the width of the positively and/or negatively directed pulses of O11 and O12.

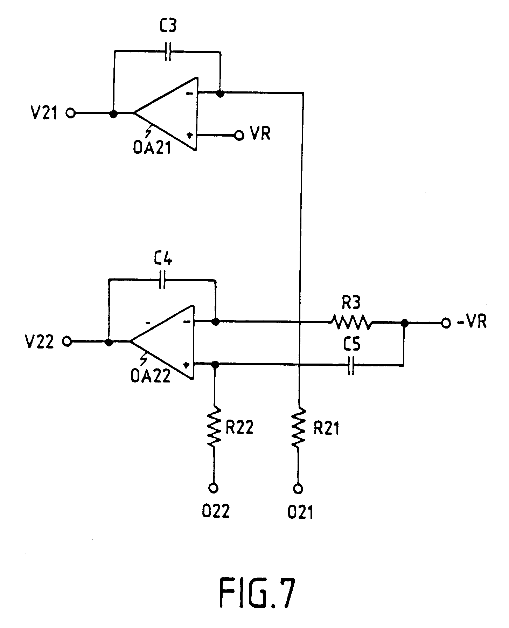

Finally, reference is made to Fig. 7 representing an integrator and comparator circuit to be substituted for the filter circuit LPF2 and the comparator circuit COMP2 of Fig. 1. The advantage of this replacement circuit is that it has a smaller number of poles than LPF2/COMP2 so that it is easier to make it stable.

In the same way as in Fig. 1 the terminals O21 and O22 are connected through resistances R21 and R22 with the minus and plus terminals of respective operational amplifiers OA21 and OA22. However, no capacitor C2 is connected between these terminals, but each of the amplifiers OA21 and OA22 is provided with a respective integration capacitor C3 and C4 which is connected between the minus terminal and the output terminal. Further, the reference voltage -VR is not directly connected to the minus terminal of OA22, but it is connected to this minus terminal via the resistance R3. Moreover -VR is connected to the plus terminal of OA22 via capacitor C5.

In a preferred embodiment $R21 = R22 = R3$ and $C3 = C4 = C5$ so that when $R21.C3 = T1$ and $R22.C5 = R3.C5 = T2$ the output voltages V21 and V22 of OA21 and OA22 may be written as follows.

$$V21 \;=\; VR \;-\; \frac{1}{T1} \int (VO21 \;-\; VR)dt \qquad\qquad (15)$$

$$and \;\; V22 \;=\; -VR \;+\; \frac{1}{T2} \int (VO22 \;+\; VR)dt \qquad\qquad (16)$$

From this it folows that the function of these circuits is the same as that of LPF2 and COMP2. Thereby OA21 is connected as an inverting integrator/comparator, whilst OA22 is connected as a non-inverting integrator/comparator.

While the principles of the invention have been described above in connection with specific apparatus, it is to be clearly understood that this description is made only by way of example and not as a limitation on the scope of the invention as defined by the claims.

## Claims

1. Converter device including a first conversion circuit (CC1, LPF1) for converting a digital input signal (PDM) to an output signal (OUT11/12), said conversion depending upon parameters (VDD, VSS) that may deviate from their nominal values, characterized in that a second conversion circuit (CC2, LPF2) performs on an auxiliary digital input signal (PDMR) a conversion to an auxiliary output signal (OUT21/22) under the control of regulated digital control signals (CL1, CL2) in a way similar to the conversion performed by said first conversion circuit (CC1, LPF1), said auxiliary digital input signal (PDMR) being so chosen that said auxiliary output signal (OUT21/22) depends on said parameters (VDD, VSS) in a similar way as said output signal (OUT11/12) and has a nominal value established by a reference value (VR, -VR) which is independent from said parameters (VDD, VSS) and their deviations, that said first conversion circuit (CC1, LPF1) converts said digital input signal (PDM) to said output signal (OUT11/12) under the control of said regulated digital control signals (CL1, CL2) which are dependent on said parameters (VDD, VSS) and are provided by a digital control signal generator (PWM2) forming part, together with said second conversion circuit (CC2, LPF2) and an error measurement circuit (COMP2), of a negative feedback control loop (CC2, LPF2, COMP2, PWM2) which regulates said regulated digital control signals (CL1, CL2) in such a way that the influence thereon of said deviations of said parameters (VDD, VSS) from their reference values is compensated, and that said error measurement circuit (COMP2) compares said auxiliary output signal (OUT21/22) with said reference value (VR, -VR) and provides thereby an error measurement signal (V21, V22) which is proportional to the difference between the compared signals and which is function of said deviations of said parameters (VDD, VSS) from their nominal values, said error measurement signal (V21, V22) controlling said digital control signal generator (PWM2) which accordingly regulates said regulated digital control signals (CL1, CL2).

2. Converter device according to claim 1, characterized in that said second conversion circuit (CC2, LPF2) generates auxiliary signals (OUT21, OUT22) which are each only dependent from a respective one of said parameters (VDD, VSS), and that said measurement circuit (COMP2) derives from said auxiliary signals (OUT21, OUT22) respective measurement signals (V21, V22) which are respectively only function of the influence of a variation of the corresponding parameter and which control said signal generator (PWM2) in such a manner that this variation is compensated on a respective one of said control signals (CL1, CL2).

3. Converter device according to claim 1,
characterized in that each of the input signals (PDM, PDMR) may change between two voltage levels (VDD′ VSS′) the duration of which is equal to one or more periods (T) and that each conversion circuit (CC1, LPF1; CC2, LPF2) includes at least one converting circuit (C11/12/21/22) to convert the one/other (VDD′/VSS′) of said two voltage levels of the input signal (PMD, PDMR), under the control of said control signals (CL1, CL2), to a signal (O21/22/21/22/) consisting of a plurality of one or more first/second pulses which follow each other with said period (T) and vary between voltage levels of a first/second (VDD, VAG/VAG, VSS) pair of voltage levels and have a first/second duration which is equal to that of first (CL1) and second (CL2) control signals and is smaller than said period (T).

4. Converter device according to claim 3,
characterized in that said first (VDD, VAG) and second (VAG, VSS) pair of voltage levels are constituted by a common fixed third voltage level (VAG) and a respective first (VDD) and second (VSS) variable level, said first (VDD) and second (VSS) voltage levels constituting said parameters.

5. Converter device according to claim 4,
characterized in that said third voltage level (VAG) is located between said first (VDD) and second (VSS) voltage levels.

6. Converter device according to claim 3,
characterized in that said first/second (CC1, LPF1/CC2, LPF2) conversion circuits each include a first (CC11, CC21) and a second (CC12, CC22) converting circuit to which said first/second (PDM/PDMR) input signal and the complement ($\overline{\text{PDM}}/\overline{\text{PDMR}}$) thereof are applied respectively.

7. Converter device according to claim 6,
characterized in that said first input signal (PDM) is a pulse density modulated signal due to which said first (C11) and second (C12) converting circuits of the first conversion circuit (CC1, LPF1) generate first (O11) and second (O12) ternary signals which are constituted by first pulses as well as by second pulses.

8. Converter device according to claim 6,
characterized in that said second input signal (PDMR) is a constant signal (VDD) which is such that said first (CC21) and second (CC22) converting circuits of said second conversion circuit (CC2, LPF2) respectively generate first (O21) and second (O22) binary signals which are only constituted by first and second pulses respectively.

9. Converter device according to claims 4 and 6,
characterized in that each converting circuit (CC1/12/21/22) includes :
- a logic circuit (LC11/12/21/22) which is controlled by said control signals (CL1, CL2) and to which an input signal is applied and which generates the following gating signals:

$$\text{PDA} = \overline{\text{CL1.PDM}}$$
$$\text{NDA} = \text{CL2.}\overline{\text{PDM}}$$
$$\text{XA} = \overline{\text{PDA} + \text{NDA}}$$

wherein CL1 and CL2 are said control signals and PDM is said input signal;
- a switching circuit (PM1/3, NM1/3; PM2/4, NM2/4) which is fed by said first (VDD), second (VSS) and third (VAG) voltage levels and is controlled by said gating signals and generates on its output (O11/12/21/22) an output signal whose level is equal to said first or second voltage level if PDA is equal to said second voltage level (VSS) and NDA is equal to said first voltage level (VDD) respectively and of which the level is otherwise equal to said third voltage level (VAG).

8

**10.** Converter device according to claim 9,
characterized in that said switching circuit is constituted by a first (PM1), second (NM1) and third (PG1) electronic switch which are respectively connected between said first (VDD), second (VSS) and third (VAG) voltage level and a common output (O11/12/21/22) and are controlled by said gating signals PDA, NDA and XA respectively.

**11.** Converter device according to claim 10,
characterized in that said first, second and third switch are respectively constituted by a first PMOS transistor (PM1), a first NMOS transistor (NM1) and a passgate transistor (PG1), said first PMOS and NMOS transistors (PM1, NM1) being connected in series and said first PMOS transistor, said first NMOS transistor and said passgate transistor being controlled by said gating signals PDA, NDA and XA, $\overline{XA}$ respectively.

**12.** Converter device according to claim 10,
characterized in that the drain electrode of said first PMOS transistor (PM1) is connected to the joined source and drain electrodes of a compensation second PMOS transistor (PM3) whose gate is controlled by the gate signal $\overline{PDA}$, whilst the drain electrode of said first NMOS transistor (NM3) is connected to the joined source and drain electrodes of a compensation second NMOS transistor (NM3) whose gate is controlled by the gate signal $\overline{NDA}$.

**13.** Converter device according to claim 3,
characterized in that each conversion circuit (CC1, LPF1; CC2, LPF2) includes an integrator circuit (LPF1, LPF2) to integrate the signal comprising pulses generated by a converting circuit (CC11/12/21/22) and to thus generate integration signals (OUT11/12/21/22).

**14.** Converter device according to claims 7 and 13,
characterized in that integration signals (OUT11/12) of the first (CC11) and second (CC12) converting circuits of the first conversion circuit (CC1, LPF1) constitute the complementary output signals of this circuit, whereby said first conversion circuit is a digital-to-analog converter.

**15.** Converter device according to claims 8 and 13,
characterized in that integration signals (OUT21/22) of the first (CC21) and second (CC22) converting circuits of the second conversion circuit (CC2, LPF2) constitute first (OUT21) and second (OUT22) of said auxiliary signal which are only dependent of said first (VDD) and second (VSS) variable voltage levels and of the first (T1) and second (CL2) control signals respectively and which are therefore only dependent. of the first and second surface of the pulses of the first (O21) and second (O22) binary signals.

**16.** Converter device according to claim 15,
characterized in that said measurement circuit (COMP2) compares the magnitude of each of said first (OUT21) and second (OUT22) auxiliary signals with a first (VR) and second (-VR) reference value respectively and generates a corresponding first (V21) and second (V22) measurement signal which is a measure of the influence of a variation of said first and second surface.

**17.** Converter device according to claim 16,
characterized in that said integrator circuit is an RC lowpass filter (LPF2), whilst said measuring circuit is constituted by first (OA21) and second (OA22) operational amplifiers which are connected as comparators to compare said first (OUT21) and second (OUT22) auxiliary signals with said first (VR) and second (-VR) reference vaules.

**18.** Converter device according to claim 16,
characterized in that said integrator circuit and said measurement circuit are constituted by first (OA21) and second (OA22) operational amplifiers which are respectively connected as an inverting amplifier/comparator and as a non-inverting amplifier/comparator to integrate the signals (O21, O22) provided by the first (CC21) and second (CC22) converting circuit of said second conversion circuit (CC2) and to compare these signals with said first (VR) and second (-VR) reference values.

EP 0 310 170 B1

19. Converter device according to claim 16,
characterized in that said first/second reference value (VR, -VR) is a measure of the surface of a first/second pulse when said first/second voltage level (VDD/VSS) has its nominal value and said first/second control signals have their first/second nominal duration (T1 = T/3, T2 = T/3).

20. Converter device according to claim 16,
characterized in that said signal generator (PWM2) includes first (PWMC21) and second (PWMC22) pulse width modulators which are respectively controlled by said first (V21) and second (V22) measurement signals in such a way that they respectively change the first (T1) and second (T2) duration of said first (CL1) and second (CL2) control signals and thus compensate a variation of said surface.

**Patentansprüche**

1. Umsetzungsvorrichtung, welche eine erste Umsetzungsschaltung (CC1, LPF1) zur Umsetzung eines digitalen Eingangssignals (PMS) in ein Ausgangssignal (OUT11/12) enthält, bei der die Umsetzung von Parametern (VDD, VSS) abhängt, welche von ihren Nennwerten abweichen können, gekennzeichnet durch folgende Merkmale:
a) eine zweite Umsetzungsschaltung (CC2, CL2) erzeugt aus einem digitalen Hilfseingangssignal (PDMR) ein Hilfsausgangssignal (OUT21/22) durch Steuerung mit einem stabilisierten digitalen Steuersignal (CL1, CL2) in einer der von der ersten Umsetzungsschaltung (CC1, LPF1) durchgeführten Umsetzung ähnlichen Weise;
b) das digitale Hilfseingangssignal (PDMR) ist derart gewählt, daß das Hilfsausgangssignal (OUT21/22) von den Parametern (VDD, VSS) in ähnlicher Weise wie die Ausgangssignale (OUT11/12) abhängt und einen von einem Bezugswert (VR, -VR) den Parametern (VDD, VSS) und deren Abweichungen unabhängig ist;
c) die erste Umsetzungsschaltung (CC1, LPF1) setzt das digitale Eingangssignal (PDM) mit Hilfe der stabilisierten digitalen Steuersignale (CL1, CL2) in das Ausgangssignal (OUT11/12) um, wobei die digitalen Steuersignale von den Parametern (VDD, VSS) abhängig sind und von einem digitalen Steuersignalgenerator (PWM2) geliefert werden;
d) der digitale Steuersignalgenerator (PWM2) ist gemeinsam mit der zweiten Umsetzungsschaltung (CC2, LPF2) und einer Fehlermeßschaltung (COMP2) Teil einer Gegenkopplungsschleife (CC2, LPF2, COMP2, PWM2), welche die stabilisierten digitalen Steuersignale (CL1, CL2) in der Weise stabilisiert, daß der Einfluß der Abweichungen der Parameter (VDD, VSS) darauf durch deren Bezugswert kompensiert ist;
e) die Fehlermeßschaltung (COMP2) vergleicht das Hilfsausgangssignal (OUT21/22) mit dem Bezugswert (VR, -VR) und liefert ein Fehlermeßsignal (V21, V22), welches zur Differenz zwischen den verglichenen Signalen proportional ist und eine Funktion der Abweichungen der Parameter (VDD, VSS) von ihrem Nennwert ist;
f) das Fehlermeßsignal (V21, V22) steuert den digitalen Steuersignalgenerator (PWM2), der die stabilisierten digitalen Steuersignale (CL1, CL2) in entsprechender Weise steuert.

2. Umsetzungsvorrichtung nach Anspruch 1,
dadurch gekennzeichnet, daß die zweite Umsetzungsschaltung (CC2, LPL2) Hilfssignale (OUT21, OUT22) erzeugt, welche nur von einem der Parameter (VDD, VSS) abhängig sind, und daß die Fehlermeßschaltung (COMP2) von den Hilfssignalen (OUT21, OUT22) entsprechende Fehlermeßsignale (V21, V22) ableitet, welche nur eine Funktion des Einflusses der Veränderung der entsprechenden Parameter sind und welche den Steuersignalgenerator (PWM2) derart steuern, daß diese Veränderung an einem der Steuersignale (CL1, CL2) kompensiert ist.

3. Umsetzungsvorrichtung nach Anspruch 1,
dadurch gekennzeichnet, daß jedes der Eingangssignale (PDM, PDMR) zwischen zwei Spannungswerten pendeln kann, wobei die Dauer eine oder mehrere Perioden (T) beträgt und jede Umsetzungsschaltung (CC1, LPF1, CC2, LPF2) wenigstens eine Umsetzungsschaltung (C11/12/21/22) enthält, um den einen oder anderen der zwei Spannungspegel (VDD, VDMR) unter Verwendung der Steuersignale (CL1, CL2) in ein Signal (D21, 22, 21, 22) umzusetzen, welches aus einer Mehrzahl von einem oder mehreren ersten/zweiten Impulsen besteht, welche einander mit der Periode (T) folgen und zwischen Spannungspegeln eines ersten/zweiten (VDD, VAG/VAG, VSS) Paares von Spannungspegeln schwanken und

10

welche eine erste/zweite Dauer aufweisen, welche derjenigen des ersten (CL1) oder zweiten (CL2) Steuersignals entspricht und kleiner als die Periodendauer (T) ist.

4. Umsetzungsvorrichtung nach Anspruch 3,
dadurch gekennzeichnet, daß das erste (VDD, VAG) und das zweite (VAG, VSS) Paar der Spannungspegel aus einem gemeinsamen festen dritten Spannungspegel (VAG) und einem entsprechenden ersten (VDD) und zweiten (VSS) veränderlichen Pegel gebildet werden, wobei der erste (VDD) und der zweite (VSS) Spannungspegel die Parameter bilden.

5. Umsetzungsvorrichtung nach Anspruch 4,
dadurch gekennzeichnet, daß der dritte Spannungspegel (VAG) zwischen dem ersten (VDD) und dem zweiten (VSS) Spannungspegel liegt.

6. Umsetzungsvorrichtung nach Anspruch 3,
dadurch gekennzeichnet, daß jeder der ersten/zweiten Umsetzungsschaltungen (CC1, LPF1/CC2, LPF2) eine erste (CC11, CC21) und eine zweite (CC12, CC22) Umsetzungsschaltung enthalten, denen das erste/zweite Eingangssignal (PDM/PDMR) und dessen Komplement ($\overline{PDM}/\overline{PDMR}$) entsprechend zugeführt werden.

7. Umsetzungsvorrichtung nach Anspruch 6,
dadurch gekennzeichnet, daß das erste Eingangssignal (PDM) ein impulsdichtemoduliertes Signal ist, bei dem die erste (C11) und die zweite (C12) Umsetzungsschaltung der ersten Umsetzungsschaltung (CC1, LPF1) erste (O11) und zweite (O12) Dreifachsignale erzeugen, welche sowohl von ersten Impulsen als auch von zweiten Impulsen gebildet werden.

8. Umsetzungsvorrichtung nach Anspruch 6,
dadurch gekennzeichnet, daß das zweite Eingangssignal (PDMR) ein solches konstantes Signal (VDD) ist, daß die erste (CC21) und die zweite (CC22) Umsetzungsschaltung der zweiten Umsetzungsschaltung (CC2, LPF2) entsprechend erste (O21) und zweite (O22) binäre Signale erzeugen, welche nur von ersten und zweiten Impulsen entsprechend gebildet werden.

9. Umsetzungsvorrichtung nach den Ansprüchen 4 und 6,
dadurch gekennzeichnet, daß jede Umsetzungsschaltung (CC1/12/21/22) enthält:
eine logische Schaltung (LC11/12/21/22), die von den Steuersignalen (CL1, CL2) gesteuert ist, welcher ein Eingangssignal zugeführt wird und welche folgende Gattersignale erzeugt:

$$PDA = \overline{CL1 \cdot PDM}$$
$$NDA = CL2 \cdot \overline{PDM}$$
$$XA = PDA + NDA$$

bei denen CL1 und CL2 die Steuersignale sind und PDM das Eingangssignal ist;
einen Schaltkreis (PM1/3, NM1/3; PM2/4, NM2/4), welcher durch den ersten (VDD), zweiten (VSS) und dritten (VAG) Spannungspegel versorgt wird, von den Gattersignalen gesteuert wird und an seinem Ausgang (O11/12/21/22) ein Ausgangssignal erzeugt, dessen Pegel gleich dem ersten oder zweiten Spannungspegel ist, falls PDA mit dem zweiten Spannungspegel (VSS) übereinstimmt und NDA mit dem ersten Spannungspegel (VDD) übereinstimmt oder dessen Pegel mit dem dritten Spannungspegel (VAG) übereinstimmt.

10. Umsetzungsvorrichtung nach Anspruch 9,
dadurch gekennzeichnet, daß der Schaltkreis aus einem ersten (PM1), zweiten (NM1) und dritten (PG1) elektronischen Schalter besteht, die in entsprechender Weise zwischen den ersten (VDD), zweiten (VSS) und dritten (VAG) Spannungspegeln und einen gemeinsamen Ausgang (O11/12/21/22) geschaltet sind und von den Gattersignalen PDA, NDA und XA gesteuert sind.

11. Umsetzungsvorrichtung nach Anspruch 10,
dadurch gekennzeichnet, daß der erste, zweite und dritte Schalter aus einem ersten PMOS-Transistor (PM1), einem ersten NMOS-Transistor (NM1) und einem Passgate-Transistor (PG1) bestehen, wobei der erste PMOS-Transistor und der erste NMOS-Transistor (PM1, NM1) in Reihe geschaltet sind und der erste PMOS-Transistor, der erste NMOS-Transistor und der Passgate-Transistor von den Gattersignalen PDA, NDA und XA, $\overline{XA}$ gesteuert werden.

**12.** Umsetzungsvorrichtung nach Anspruch 10,
dadurch gekennzeichnet, daß die Drain-Elektrode des ersten PMOS-Transistors (PM1) mit den verbundenen Source- und Drain-Elektroden eines zweiten Kompensations-PMOS-Tranistors (PM3) verbunden ist, dessen Gate von dem Gatesignal $\overline{PDA}$ gesteuert ist während die Drain-Elektrode des ersten NMOS-Transistors (NM3) mit den verbundenen Source- und Drain-Elektroden eines zweiten Kompensations-NMOS-Transistors (NM3) verbunden ist, dessen Gate von dem Gatesignal $\overline{NDA}$ gesteuert ist.

**13.** Umsetzungsvorrichtung nach Anspruch 3,
dadurch gekennzeichnet, daß jede Umsetzungsschaltung (CC1, LPF1; CC2, LPF2) eine Integrationsschaltung (LPF1, LPF2) zur Integration des Signals mit den Impulsen enthält, welche von der Umsetzungsschaltung (CC11/12/21/22) erzeugt worden sind und die Integrationssignale (OUT11/12/21/22) erzeugen.

**14.** Umsetzungsvorrichtung nach den Ansprüchen 7 und 13,
dadurch gekennzeichnet, daß die Integrationssignale (OUT11/12) der ersten (CC11) und zweiten (CC12) Umsetzungsschaltung der ersten Umsetzungsschaltung (CC1, LPF1) das komplementäre dieser Schaltung bilden, wobei die erste Umsetzungsschaltung ein Digital-Analog-Wandler ist.

**15.** Umsetzungsvorrichtung nach den Ansprüchen 8 und 13,
dadurch gekennzeichnet, daß die Integrationssignale (OUT21/22) der ersten (CC21) und zweiten (CC22) Umsetzungsschaltung der zweiten Umsetzungsschaltung (CC2, LPF2) das erste (OUT21) und zweite (OUT22) der Hilfssignale bilden, welche nur von den ersten (VDD) und zweiten (VSS) veränderlichen Spannungspegeln und den ersten (T1) und zweiten (CL2) Steuersignalen abhängig sind und welche daher von der ersten und zweiten Oberfläche der Impulse der ersten (O21) und zweiten (O22) Binärsignale abhängig sind.

**16.** Umsetzungsvorrichtung nach Anspruch 15,
dadurch gekennzeichnet, daß die Meßschaltung (COMP2) die Größe von jedem der ersten (OUT21) und zweiten (OUT22) Hilfssignale mit einem ersten (VR) und zweiten (-VR) Vergleichswert vergleicht und ein entsprechendes erstes (V21) und zweites (V22) Meßsignal erzeugt, welches ein Maß für den Einfluß auf die Veränderung der ersten und zweiten Oberfläche ist.

**17.** Umsetzungsvorrichtung nach Anspruch 16,
dadurch gekennzeichnet, daß die Integrationsschaltung ein RC-Tiefpaß-Filter (LPF2) ist während die Meßschaltung aus einem ersten (OA21) und zweiten (OA22) Operationsverstärker besteht welche als Komparatoren geschaltet sind, um die ersten (OUT21) und zweiten (OUT22) Hilfssignale mit den ersten (VR) und zweiten (-VR) Bezugswerten zu vergleichen.

**18.** Umsetzungsvorrichtung nach Anspruch 16,
dadurch gekennzeichnet, daß die Integrationsschaltung und die Meßschaltung aus dem ersten (OA21) und zweiten (OA22) Operationsverstärker bestehen, welche als ein invertierender Verstärker/Komparator und als ein nichtinvertierender Verstärker/Komparator geschaltet sind, um die Signale (O21, O22), welche von der ersten (CC21) und zweiten (CC22) Umsetzungsschaltung der zweiten Umsetzungsschaltung (CC2) geliefert werden, zu integrieren und um diese Signale mit dem ersten (VR) und zweiten (-VR) Bezugswert zu vergleichen.

**19.** Umsetzungsvorrichtung nach Anspruch 16,
dadurch gekennzeichnet, daß der erste/zweite Bezugswert (VR,-VR) ein Maß für die Oberfläche der ersten/zweiten Impulse ist, wenn der erste/zweite Spannungspegel (VDD/VSS) seinen Nennwert besitzt und die ersten/zweiten Steuersignale ihre erste/zweite Nenndauer (T1 = T/3; T2 = T/3) aufweisen.

**20.** Umsetzungsvorrichtung nach Anspruch 16,
dadurch gekennzeichnet, daß der Signalgenerator (PWM2) erste (PWMC21) und zweite (PWMC22) Impulsweitenmodulatoren enthält, welche von den ersten (V21) und den zweiten (V22) Meßsignalen derart gesteuert werden, daß sie die erste (T1) und zweite (T2) Dauer der ersten (CL1) und zweiten (CL2) Steuersignale verändern und somit die Änderung der Oberfläche ändern.

**Revendications**

1. Dispositif convertisseur incluant un premier circuit de conversion (CC1, LPF1) pour convertir un signal d'entrée numérique (PDM) en un signal de sortie (OUT11/12), ladite conversion dépendant de paramètres (VDD, VSS) qui peuvent s'écarter de leurs valeurs nominales, caractérisé en ce qu'un deuxième circuit de conversion (CC2, LPF2) effectue la conversion d'un signal d'entrée numérique auxiliaire (PDMR) en un signal de sortie auxiliaire (OUT21/22) sous la commande de signaux de commande numériques régulés (CL1, CL2), d'une façon similaire à la conversion effectuée par ledit premier circuit de conversion (CC1, LPF1), ledit signal d'entrée numérique auxiliaire (PDMR) étant choisi de sorte que ledit signal de sortie auxiliaire (OUT21/22) dépende desdits paramètres (VDD/VSS) de la même façon que ledit signal de sortie (OUT21/22) et ait une valeur nominale établie par une valeur de référence (VR, -VR) qui soit indépendante desdits paramètres (VDD, VSS) et de leurs variations, en ce que ledit premier circuit de conversion (CC1, LPF1) convertit ledit signal d'entrée numérique (PDM) en ledit signal de sortie (OUT11/12) sous la commande desdits signaux de commande numériques régulés (CL1, CL2) qui sont dépendants desdits paramètres (VDD, VSS) et sont fournis par un générateur de signaux de commande numériques (PWM2) faisant partie, en même temps que ledit deuxième circuit de conversion (CC2, LPF2) et un circuit d'évaluation d'erreur (COMP2), d'une boucle de commande à contre-réaction (CC2, LPF2, COMP2, PWM2) qui régule lesdits signaux de commande numériques régulés (CL1, CL2) de façon que soit compensée l'influence sur ceux-ci desdites variations desdits paramètres (VDD, VSS), par rapport à leurs valeurs de référence, et en ce que ledit circuit d'évaluation d'erreur (COMP2) compare ledit signal de sortie auxiliaire (OUT21/22) à ladite valeur de référence (VR, -VR) et fournit en conséquence un signal d'évaluation d'erreur (V21, V22) qui est proportionnel à la différence entre les signaux comparés et qui est fonction desdites déviations desdits paramètres (VDD, VSS) par rapport à leurs valeurs nominales, ledit signal d'évaluation d'erreur (V21, V22) commandant ledit générateur de signaux de commande numériques (PWM2) qui régule en conséquence lesdits signaux de commande numériques régulés (CL1, CL2).

2. Dispositif convertisseur conforme à la revendication 1 caractérisé en ce que ledit deuxième circuit de conversion (CC2, LPF2) engendre des signaux auxiliaires (OUT21, OUT22) qui sont chacun respectivement dépendants seulement d'un desdits paramètres (VDD, VSS) et en ce que ledit circuit d'évaluation (COMP2) dérive respectivement desdits signaux auxiliaires (OUT21, OUT22) des signaux d'évaluation (V21, V22) qui sont respectivement fonction seulement de l'influence d'une variation du paramètre correspondant et qui commandent ledit générateur de signaux (PWM2) de façon que cette variation soit compensée sur l'un correspondant desdits signaux de commande (CL1, CL2).

3. Dispositif convertisseur conforme à la revendication 1, caractérisé en ce que chacun des signaux d'entrée (PDM, PDMR) peut changer entre deux niveaux de tension (VDD', VSS') dont la durée est égale à une ou plusieurs périodes (T) et en ce que chaque circuit de conversion (CC1, LPF1 ; CC2, LPF2) inclut au moins un circuit convertisseur (CC11/12/21/22) pour convertir l'un ou l'autre (VDD'/VSS') de ces deux niveaux de tension du signal d' entrée (PDM, PDMR), sous la commande desdits signaux de commande (CL1, CL2), en un signal (O21/22/21/22/) consistant en une pluralité d'une ou plusieurs premières/deuxièmes impulsions qui se suivent l'une l'autre avec cette période (T) et varient entre des niveaux de tension d'une première/deuxième (VDD, VAG/VAG, VSS) paire de niveaux de tension et ont une première/deuxième durée qui est égale à celle du premier (CL1) et du deuxième (CL2) signal de commande et est inférieure à ladite période (T).

4. Dispositif convertisseur conforme à la revendication 3, caractérisé en ce que lesdites première (VDD, VAG) et deuxième (VAG, VSS) paires de niveaux de tension sont constituées par un troisième niveau de tension fixe commun (VAG) et, respectivement, un premier (VDD) et un deuxième (VSS) niveaux variables, lesdits premier (VDD) et deuxième (VSS) niveaux de tension constituant lesdits paramètres.

5. Dispositif convertisseur conforme à la revendication 4, caractérisé en ce que ledit troisième niveau de tension (VAG) est situé entre lesdits premier (VDD) et deuxième (VSS) niveaux de tension.

**6.** Dispositif convertisseur conforme à la revendication 3, caractérisé en ce que lesdits premier/deuxième (CC1, LPF1 / CC2, LPF2) circuits de conversion incluent chacun un premier (CC11, CC21) et un deuxième (CC12, CC22) circuit convertisseur, auxquels lesdits premier/deuxième signaux d'entrée (PDM, PDMR) et leurs compléments ($\overline{\text{PDM}}$, $\overline{\text{PDMR}}$) sont respectivement appliqués.

**7.** Dispositif convertisseur conforme à la revendication 6, caractérisé en ce que ledit premier signal d'entrée (PDM) est un signal à modulation de densité d'impulsions grâce auquel lesdits premier (C11) et deuxième (C12) circuits convertisseurs du premier circuit de conversion (CC1, LPF1) engendrent des premier (O11) et deuxième (O12) signaux ternaires qui sont constitués par des premières impulsions et par des deuxièmes impulsions.

**8.** Dispositif convertisseur conforme à la revendication 6, caractérisé en ce que ledit deuxième signal d'entrée (PDMR) est un signal constant (VDD) qui est tel que lesdits premier (CC21 et deuxième (CC22) circuits convertisseurs dudit deuxième circuit de conversion (CC2, LPF2) engendrent respectivement des premier (O21) et deuxième (O22) signaux binaires qui sont respectivement constitués seulement par des premières et deuxièmes impulsions.

**9.** Dispositif convertisseur conforme aux revendications 4 et 6, caractérisé en ce que chaque circuit convertisseur (CC11/12/21/22) inclut :

- un circuit logique (LC11/12/21/22; qui est commandé par lesdits signaux de commande (CL1, CL2) et auquel un signal d'entrée est appliqué et qui engendre les signaux de porte suivants :

$$\text{PDA} = \overline{\text{CL1} . \text{PDM}}$$
$$\text{NDA} = \text{CL2} . \overline{\text{PDM}}$$
$$\text{XA} = \overline{\text{PDA}} + \text{NDA}$$

dans lesquels CL1 et CL2 sont lesdites signaux de commande et PDM est ledit signal d'entrée ;
- un circuit de commutation (PM1/3, NM1/3 ; PM2/4, NM2/4) qui est alimenté par lesdites premier (VDD), deuxième (VSS) et troisième (VAG) niveaux de tension et est commandé par lesdits signaux de porte et engendre sur sa sortie (O11/12/21/22) un signal de sortie dont le niveau est égal audit premier ou deuxième niveau de tension si PDA est égal audit deuxième niveau de tension (VSS) et NDA est égal audit premier niveau de tension (VDD), respectivement, et dont le niveau est dans les autres cas égal audit troisième niveau de tension (VAG).

**10.** Dispositif convertisseur conforme à la revendication 9, caractérisé en ce que ledit circuit de commutation est constitué par des premier (PM1), deuxième (NM1) et troisième (PG1) commutateurs électroniques qui sont respectivement connectés entre lesdits premier (VDD), deuxième (VSS) et troisième (VAG) niveaux de tension et une sortie commune (O11/12/21/22) et sont respectivement commandés par lesdits signaux de porte PDA, NDA et XA.

**11.** Dispositif convertisseur conforme à la revendication 10, caractérisé en ce que lesdits premier, deuxième et troisième commutateurs sont respectivement constitués par un premier transistor PMOS (PM1), un premier transistor NMOS (NM1) et un transistor de porte (PG1), lesdits premiers transistors PMOS et NMOS (PM1, NM1) étant connectés en série et ledit premier transistor PMOS, ledit premier transistor NMOS et ledit transistor de porte étant respectivement commandés par lesdits signaux de porte PDA, NDA et XA, $\overline{\text{XA}}$.

**12.** Dispositif convertisseur conforme à la revendication 10, caractérisé en ce que l'électrode de drain dudit premier transistor PMOS (PM1) est connectée aux électrodes de source et de drain interconnectées d'un deuxième transistor PMOS de compensation (PM3) dont la grille est commandée par le signal de porte $\overline{\text{PDA}}$, alors que l'électrode de drain dudit premier transistor NMOS (NM3) est connectée aux électrodes de source et de drain interconnectées d'un deuxième transistor NMOS (NM3) dont la grille est commandée par le signal de porte $\overline{\text{NDA}}$.

**13.** Dispositif convertisseur conforme à la revendication 3, caractérisé en ce que chaque circuit de conversion (CC1, LPF1 ; CC2, LPF2) comprend un circuit intégrateur (LPF1, LPF2) pour intégrer le signal consistant en impulsions engendré par un circuit convertisseur (CC11/12/21/22) et pour ainsi engendrer des signaux d'intégration (OUT11/12/21/22).

**14.** Dispositif convertisseur conforme aux revendications 7 et 11, caractérisé en ce que les signaux d'intégration (OUT11/12) des premier (CC11) et deuxième (CC12) circuits convertisseurs du premier circuit de conversion (CC1, LPF1) constituent les signaux de sortie complémentaires de ce circuit, de sorte que ledit premier circuit de conversion est un convertisseur numérique analogique.

**15.** Dispositif convertisseur conforme aux revendications 8 et 13, caractérisé en ce que les signaux d'intégration (OUT21/22) des premier (CC21) et deuxième (CC22) circuits convertisseurs du deuxième circuit de conversion (CC2, LPF2) constituent un premier (OUT21) et un deuxième (OUT22) desdits signaux auxiliaires qui sont respectivement dépendants seulement desdits premier (VDD) et deuxième (VSS) niveaux de tension variables et des premier (CL1) et deuxième (CL2) signaux de commande et qui sont par conséquent dépendants seulement des première et deuxième surfaces des impulsions des premier (O21) et deuxième (O22) signaux binaires.

**16.** Dispositif convertisseur conforme à la revendication 15, caractérisé en ce que ledit circuit d'évaluation (COMP2) compare respectivement l'amplitude de chacun desdits premier (OUT21) et deuxième (OUT22) signaux auxiliaires avec une première (VR) et une deuxième (-VR) valeur de référence et engendre en correspondance un premier (V21) et un deuxième (V22) signal d'évaluation qui est une mesure de l'influence d'une variation de ladite première ou deuxième surface.

**17.** Dispositif convertisseur conforme à la revendication 16, caractérisé en ce que ledit circuit intégrateur est une filtre passe-bas de type RC ( LPF2), tandis que ledit circuit d'évaluation est constitué par des premier (OA21) et deuxième (OA22) amplificateurs opérationnels qui sont connectés en comparateur pour comparer lesdits premier (OUT 21) et deuxième (OUT22) signaux auxiliaires avec lesdites première (VR) et deuxième (-VR) valeurs de référence.

**18.** Dispositif convertisseur conforme à la revendication 16, caractérisé en ce que ledit circuit intégrateur et ledit circuit d'évaluation sont constitués par des premier (OA21) et deuxième (OA22) amplificateurs opérationnels qui sont respectivement connectés comme un amplificateur/comparateur inverseur et un amplificateur/comparateur non-inverseur pour intégrer les signaux (O21, O22) fournis par lesdites premier (CC21) et deuxième (CC22) circuits convertisseurs dudit deuxième circuit de conversion (CC2) et pour comparer ces signaux avec lesdites première (VR) et deuxième (-VR) valeurs de référence.

**19.** Dispositif convertisseur conforme à la revendication 16, caractérisé en ce que ladite première/deuxième valeur de référence (VR, -VR) est une mesure de la surface d'une première/deuxième impulsion, lorsque ladite première/deuxième tension de référence (VDD/VSS) a sa valeur nominale et lesdits premier/deuxième signaux de commande ont leurs première/deuxième durées nominales (T1 = T/3 ; T2 = T/3).

**20.** Dispositif convertisseur conforme à la revendication 16, caractérisé en ce que ledit générateur de signaux (PWM2) inclut des premier (PWMC21) et deuxième (PWMC22) modulateurs de largeur d'impulsions qui sont respectivement commandés par lesdits premier (V21) et deuxième (V22) signaux d'évaluation de telle façon qu'ils changent respectivement les première (T1) et deuxième (T2) durées desdits premier (CL1) et deuxième (CL2) signaux de commande et ainsi compensent une variation de ladite surface.

## DAC

FIG.1

FIG.2

FIG.3

EP 0 310 170 B1

FIG.4

19

FIG.5

FIG.6

FIG.7